# EUROPEAN PATENT APPLICATION

(11) **EP 4 489 439 A1**
(43) Date of publication of application: **08.01.2025**
(21) Application number: 23763204.7
(22) Date of filing: 09.02.2023
(51) Int. Cl.: H04R 19/04

(54) **MEMS ELEMENT**

(30) Priority: 04.03.2022 JP 2022033650
(71) Applicant: Nisshinbo Micro Devices Inc., Tokyo 103-8456 (JP)
(72) Inventor: KUROMARU, Yoshimitsu, Fujimino-shi, Saitama 356-8510 (JP); KOUDA, Yoshiyuki, Fujimino-shi, Saitama 356-8510 (JP); MAEDA, Kiyoshi, Fujimino-shi, Saitama 356-8510 (JP); TAKAHASHI, Hiroshi, Fujimino-shi, Saitama 356-8510 (JP); YAMAMOTO, Keita, Fujimino-shi, Saitama 356-8510 (JP); KINOSHITA, Jun, Fujimino-shi, Saitama 356-8510 (JP)
(74) Representative: M. Zardi & Co S.A.
(86) International application number: PCT/JP2023/004434
(87) International publication number: WO 2023/166942

(57) **Abstract**

A MEMS element comprising: a substrate (1) comprising a back chamber (9); a vibrating membrane (3) joined onto the substrate (1) and comprising a movable electrode; and a backplate (7) comprising a fixed electrode (5) disposed so as to face the movable electrode. A wall (10A) connected to the backplate (7), slits (11a), (11b), and a plurality of vibrating portions (12A), (12B) are formed in the vibrating membrane (3), the plurality of vibrating portions (12A), (12B) are present in either one of a region surrounded by a portion in which the wall (10A) and the vibrating membrane (3) are joined and a region between the portion in which the wall (10A) and the vibrating membrane (3) are joined and the peripheral portion of the vibrating membrane (3), and at least one vibrating portion is present in the region between the portion in which the wall (10A) and the vibrating membrane (3) are joined and the peripheral portion of the vibrating membrane (3).

## Description

### TECHNICAL FIELD

The present invention relates to a MEMS element and particularly relates to a MEMS element used as a microphone, various sensors, and the like.

### BACKGROUND ART

As a MEMS (Micro electro mechanical systems) element using a semiconductor process, a capacitance-type MEMS element is known, in which a backplate including a fixed electrode equipped with a plurality of acoustic holes, and a vibrating membrane including a movable electrode are disposed on a substrate across an insulating film to be a spacer.

The capacitance-type MEMS element detects, as a capacitance change between the movable electrode and the fixed electrode, displacement of the movable electrode caused by a vibration of the vibrating membrane and outputs the detected capacitance change as a detection signal. This type of MEMS element is disclosed in Patent Document 1, for example.

### PRIOR ART DOCUMENT

### Patent Document

Patent Document 1: JP 2011-055087 A

### SUMMARY OF THE INVENTION

### PROBLEM TO BE SOLVED BY THE INVENTION

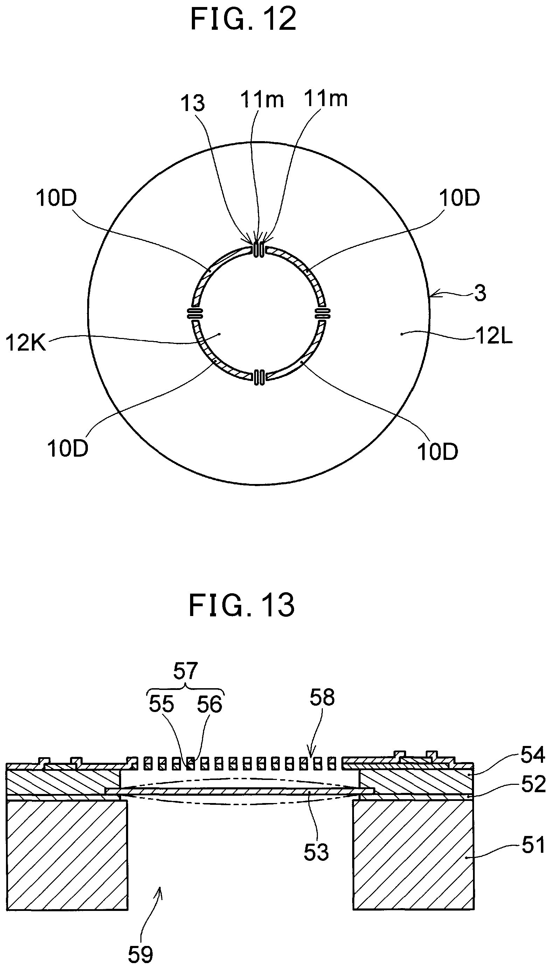

For example, a schematic cross-sectional view to explain a conventional capacitance-type MEMS element is shown in FIG. 13. As shown in FIG. 13, in the conventional capacitance-type MEMS element, an insulating film 52 is formed on a substrate 51 to be a support substrate and a vibrating membrane 53 including a conductive movable electrode is formed on the insulating film 52. Moreover, a spacer 54 formed of an insulating film and a backplate 57 composed of a conductive fixed electrode 55 and an insulating film 56 are laminated, forming an air gap structure. Letter 58 is an acoustic hole formed in the backplate 57 and letter 59 is a back chamber formed in the substrate 51. When a sound pressure and the like are applied to such a capacitance-type MEMS element, the central portion of the vibrating membrane 53 vibrates to a large extent. FIG. 13 shows, with broken lines, the state in which the vibrating membrane 53 swings to the backplate 57 side and the state in which it swings to the back chamber 59 side.

In the capacitance-type MEMS element, displacement of the vibrating membrane 53, which is shown by the broken line in FIG. 13, is detected as a change in the capacitance value between the vibrating membrane 53 to be a movable electrode and the fixed electrode 55 of the backplate 57, and the detected change is output as a detection signal. In the vibrating membrane 53, the peripheral portion is joined to the substrate 51 and the like, so that the amplitude at the peripheral portion is smaller compared to the amplitude at the central portion of the vibrating membrane 53.

Generally, in the capacitance-type MEMS element, when the spring constant of the vibrating membrane 53 is reduced to increase the SNR (signal-to-noise ratio), displacement becomes too large, causing the vibrating membrane 53 and the backplate 57 to be in contact with each other or causing a difference to be produced in the respective amplitude amounts at the central portion of the vibrating membrane 53, at which the displacement is large, and at the peripheral portion, at which the displacement is small. As a result, the area of the vibrating membrane 53, which is displaced parallel to the backplate 57, becomes small and the AOP (Acoustic overload point) deteriorates. There is a problem that, conversely, in the vibrating membrane 53, in which the displacement of the vibrating membrane 53 is small, deterioration of the AOP can be prevented but the SNR cannot be increased.

However, in a case that the capacitance-type MEMS element is used as a microphone, it is necessary to improve the AOP while suppressing the reduction in SNR.

Thus, a problem to be solved of the present invention is to provide a MEMS element having a superior SNR and an improved AOP.

### MEANS TO SOLVE THE PROBLEM

A MEMS element of the present invention, in one embodiment, is a MEMS element comprising: a substrate comprising a back chamber; a vibrating membrane joined onto the substrate, wherein the vibrating membrane comprises a movable electrode; and a backplate comprising a fixed electrode disposed so as to face the movable electrode, wherein the vibrating membrane has a wall connecting the backplate and the vibrating membrane, a slit disposed along at least either one of a portion joined to the wall and a peripheral portion of the vibrating membrane, and a plurality of vibrating portions, wherein each of the plurality of vibrating portions is present in either one of: (i) a region surrounded by a portion in which the wall and the vibrating membrane are joined, and (ii) a region between the portion in which the wall and the vibrating membrane are joined and the peripheral portion of the vibrating membrane, and wherein at least one of the plurality of vibrating portions is present in the region of (ii).

### EFFECTS OF THE INVENTION

According to the MEMS element of the present invention, a part of the vibrating membrane is joined to the backplate by the wall, so that the amplitude of the vibrating membrane is suppressed and, moreover, a detection signal having an improved AOP is output from a vibrating portion formed by providing a slit to the vibrating membrane along at least either one of a portion joined to the wall and the peripheral portion. A plurality of vibrating portions is formed on the vibrating membrane, a large detection signal as a whole is obtained, so that the SNR is not reduced. In this way, according to the present invention, providing a MEMS element having an excellent SNR and an improved AOP is made possible. As a result, a MEMS element for a high-performance microphone can be obtained.

### BRIEF DESCRIPTION OF THE DRAWINGS

FIG. 1 is a schematic cross-sectional view of a MEMS element being one embodiment (Embodiment 1) of the present invention.
FIG. 2 is a schematic plan view showing a part of a vibrating membrane in the MEMS element of Embodiment 1.
FIG. 3 is a schematic plan view showing a part of a vibrating membrane in the MEMS element of a variation of Embodiment 1.
FIG. 4 is a schematic plan view showing a part of a vibrating membrane in the MEMS element of another variation of Embodiment 1.
FIG. 5 is a schematic cross-sectional view of a MEMS element being another embodiment (Embodiment 2) of the present invention.
FIG. 6 is a schematic plan view showing a part of a vibrating membrane in the MEMS element of Embodiment 2.
FIG. 7 is a schematic plan view showing a part of a vibrating membrane in the MEMS element of a variation of Embodiment 2.
FIG. 8 is a schematic plan view showing a part of a vibrating membrane in the MEMS element of another variation of Embodiment 2.
FIG. 9 is a schematic cross-sectional view of a MEMS element being yet another embodiment (Embodiment 3) of the present invention.
FIG. 10 is a schematic plan view showing a part of a vibrating membrane in the MEMS element of Embodiment 3.
FIG. 11 is a schematic plan view showing a part of a vibrating membrane in the MEMS element of a variation of Embodiment 3.
FIG. 12 is a schematic plan view showing a part of a vibrating membrane in a MEMS element of yet another embodiment (Embodiment 4) of the present invention.
FIG. 13 is a schematic cross-sectional view of a conventional capacitance-type MEMS element.

### EMBODIMENT FOR CARRYING OUT THE INVENTION

A MEMS element of the present invention will be described with reference to the drawings, but the present invention is not to be limited thereto, so that members, materials, and the like described below can be variously modified within the range of the gist of the present invention. Moreover, in the drawings, identical letters indicate equivalent or identical items, and the size, the positional relationship, and the like among each of the components are provided for convenience, so that they do not strictly reflect the actual situation.

### (Embodiment 1)

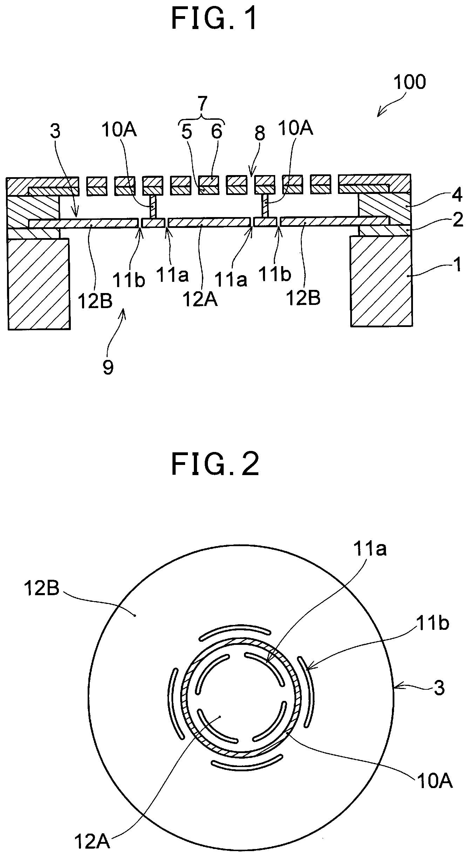

FIG. 1 is a schematic cross-sectional view to explain Embodiment 1 of a MEMS element of the present invention. As shown in FIG. 1, in a MEMS element 100 according to Embodiment 1, an insulating film 2 composed of a thermal oxide film and the like, for example, is formed on a substrate 1, as a support substrate, which is composed of a silicon substrate and the like, for example, and a vibrating membrane 3 including a conductive movable electrode composed of polysilicon and the like, for example, is formed on the insulating film 2. Moreover, an insulating spacer 4 composed of a USG (Undoped silicate glass) and the like, for example, and a backplate 7 are laminated, which backplate 7 includes a conductive fixed electrode 5 composed of polysilicon and the like, for example, and an insulating film 6 composed of a silicon nitride and the like, for example. Letter 8 denotes an acoustic hole formed in the backplate 7 and letter 9 denotes a back chamber formed in the substrate 1.

In the MEMS element 100 of the present embodiment, each of the vibrating membrane 3 and the backplate 7 is joined to a wall 10A and connected to each other, and slits 11a and 11b disposed along a portion joined to the wall 10A are provided.

FIG. 2 is a schematic plan view showing a part of the vibrating membrane 3 in the MEMS element 100 shown in FIG. 1 and is a view to explain the arrangement of the wall 10A, and the slits 11a and 11b. The back chamber 9 formed in the substrate 1 in FIG. 1 is circular and the outer periphery in FIG. 2 corresponds to the inner periphery of the spacer 4 on the substrate 1. The schematic cross-sectional view shown in FIG. 1 is a cross-sectional view passing through the center of the vibrating membrane 3 and the slits 11a and 11b in FIG. 2.

As shown in FIG. 2, in a case that a portion of the vibrating membrane 3, which portion corresponds to the back chamber 9, is circular, the wall 10A with ring shape is disposed in a manner concentric to the center of the vibrating membrane 3. The slit 11a is disposed along the inner side of the wall 10A and the slit 11b is disposed along the outer side of the wall 10A, respectively, thereby vibrating portions 12A and 12B are formed in a region on the inner side of a joining portion in which the vibrating membrane 3 and the wall 10A are joined and in a region between the outer periphery of the joining portion and the peripheral portion of the vibrating membrane 3, respectively.

The vibrating portion 12A will be described. The slit 11a is formed on the inner side of a portion of the vibrating membrane 3 shown in FIG. 2, which portion is joined to the wall 10A, along the portion joined to the wall 10A. By forming the slit 11a, it is made easy for a region, a vibration of which region is restricted by the wall 10A, to vibrate, and a region on the inner side of the slit 11a becomes the vibrating portion 12A. The vibration characteristic of the vibrating portion 12A varies depending on the material composing the vibrating membrane 3, the thickness, and the size of the region to be the vibrating portion 12A. Moreover, the vibration characteristic varies depending on the shape and arrangement of the slit 11a, such as the number and length of the slits 11a, the dimensions between the slits, the spacing between the slit 11a and the wall 10A, and the like.

Next, the vibrating portion 12B will be described. The slit 11b is formed on the outer side of a portion, joined to the wall 10A, of the vibrating membrane 3 shown in FIG. 2, along the joined portion. By forming the slit 11b, it is made easy for a region, a vibration of which region is restricted by the wall 10A, to vibrate, and a region between the slit 11b and the peripheral portion of the vibrating membrane 3 becomes the vibrating portion 12B. The vibration characteristic of the vibrating portion 12B varies depending on the material composing the vibrating membrane 3, the thickness, and the size of the region to be the vibrating portion 12B. Moreover, the vibration characteristic also varies depending on the shape and arrangement of the slit 11b.

Therefore, in the MEMS element 100 of the present embodiment, the vibration characteristics of the vibrating portions 12A and 12B are respectively adjusted, and a detection signal output from the vibrating portion 12A and a detection signal output from the vibrating portion 12B are added to be output. The adjustment of the vibration characteristics of the vibrating portion 12A and the vibrating portion 12B is to be carried out such that each amplitude of vibration becomes large and the area of the region with the large amplitude increases. As a result, a sufficiently large SNR can be obtained.

Besides, the MEMS element 100 of the present embodiment comprises the wall 10A in comparison to the conventional MEMS device, so that the amplitude of the vibration of the vibrating portions 12A and 12B is small. In other words, a detection signal having an improved AOP is output from each of the vibrating portions 12A and 12B.

Specifically, a comparative study was carried out with the conventional MEMS element shown in FIG. 13 and the MEMS element 100 of the present Embodiment shown in FIGS. 1 and 2, the vibration characteristics of the conventional MEMS element and the MEMS element 100 being adjusted such that the SNRs are almost equal to each other. When the levels at which the ratio of the total harmonic distortion (THD) + noise to the component of the original signal reaches 10% are compared, the conventional MEMS element has 122.2 dBSPL, while the MEMS element 100 of the present embodiment has 140.5 dBSPL, so that an improvement in AOP was confirmed.

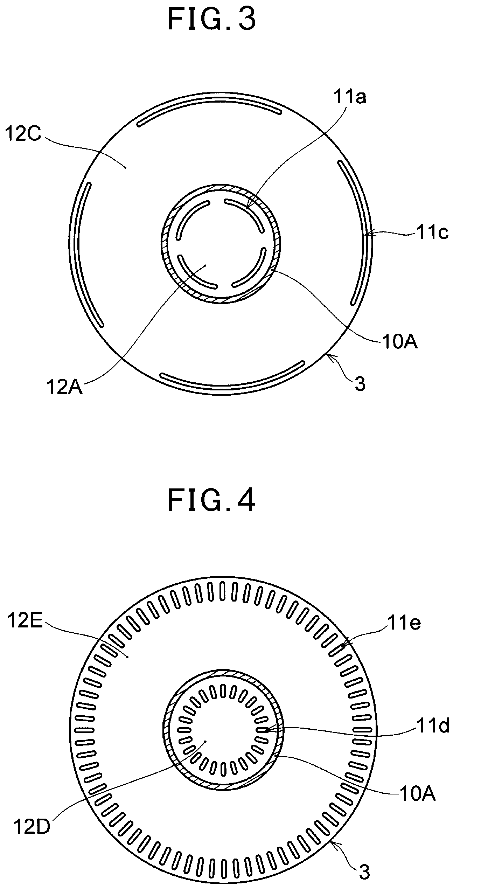

Next, a variation of Embodiment 1 of the MEMS element of the present invention will be described. FIG. 3 is a schematic plan view showing a part of the vibrating membrane 3 in the MEMS element of the variation of Embodiment 1 and is a schematic plan view corresponding to FIG. 2 in Embodiment 1. In the MEMS element of the present variation, in the same manner as the MEMS element 100 of Embodiment 1, each of the vibrating membrane 3 and the backplate 7 is joined to the wall 10A and connected to each other, and the slit 11a disposed along a portion joined to the wall 10A is provided. On the other hand, the MEMS element of the present variation differs from the MEMS element 100 of Embodiment 1 in that it comprises, instead of the slit 11b, a slit 11c disposed along the peripheral portion of the vibrating membrane 3.

As shown in FIG. 3, the arrangement of the wall 10A is similar to that in Embodiment 1, so that the slit 11a is arranged on the inner side of the wall 10A and the slit 11c is arranged along the peripheral portion of the vibrating membrane 3, respectively, thereby the vibrating portion 12A is formed in a region on the inner side of a joining portion in which the vibrating membrane 3 and the wall 10A are joined, and a vibrating portion 12C is formed in a region between the outer periphery of the joining portion and the peripheral portion of the vibrating membrane 3, respectively.

The vibrating portion 12A has a structure similar to that of the vibrating portion 12A described in Embodiment 1 above, and the same applies to the vibration characteristic thereof.

The vibrating portion 12C will be described. On the outer side of a portion of the vibrating membrane 3 shown in FIG. 3, which portion is joined to the wall 10A, a region is present, a vibration of which region is restricted by being joined to the spacer 4, the insulating film 2, and the substrate 1; however, by forming the slit 11c along the peripheral portion of the vibrating membrane 3, it is made easy for the region to vibrate, and a region between the wall 10A and the slit 11c becomes the vibrating portion 12C. The vibration characteristic of the vibrating portion 12C varies depending on the material composing the vibrating membrane 3, the thickness, and the size of the region to be the vibrating portion 12C. Moreover, the vibration characteristic also varies depending on the shape and arrangement of the wall 10A and the slit 11c.

Therefore, in the MEMS element of the present variation, the vibration characteristics of the vibrating portions 12A and 12C are respectively adjusted, and a detection signal output from the vibrating portion 12A and a detection signal output from the vibrating portion 12C are added to be output. The adjustment of the vibration characteristics of the vibrating portion 12A and the vibrating portion 12C is to be carried out such that each amplitude of vibration becomes large and the area of the region with the large amplitude increases. In the MEMS element of the present variation, compared to the vibrating portion 12B described in Embodiment 1 above, the vibrating portion 12C is made easy to vibrate at the peripheral portion of the vibrating membrane 3. As a result, the area of the region with the large amplitude can be increased, making it possible to obtain a sufficiently large SNR.

Besides, the MEMS element of the present variation is also configured to comprise the wall 10A in comparison to the conventional MEMS element, so that the amplitude of the vibration of the vibrating portions 12A and 12C is small. In other words, a detection signal having an improved AOP is output from each of the vibrating portions.

Moreover, in the MEMS element of the present variation, the slit 11b disposed along the outer periphery of the wall 10A, which slit 11b is described in the MEMS element 100 of Embodiment 1, can also be further added. In a case that the MEMS element of the present variation is configured to have a structure comprising the slit 11b, the amplitude of the vibration of the vibrating portion 12C can further be increased.

Next, another variation of Embodiment 1 of the MEMS element of the present invention will be described. FIG. 4 is a schematic plan view showing a part of the vibrating membrane 3 in the MEMS element of another variation of Embodiment 1 and is a schematic plan view corresponding to FIG. 2 in Embodiment 1. In the MEMS element of the present variation, in the same manner as the MEMS element 100 of Embodiment 1, each of the vibrating membrane 3 and the backplate 7 is joined to the wall 10A and connected to each other. Moreover, the MEMS element of the present variation is similar to the variation of Embodiment 1 in that it comprises a slit disposed along a portion joined to the wall 10A and comprises a slit disposed along the peripheral portion of the vibrating membrane 3 and differs from the variation of Embodiment 1 in the shape of the slit. The slit of the present variation has an opening elongated in the radial direction of the vibrating membrane 3, which opening is disposed such that it is lined up in a plurality.

As shown in FIG. 4, the arrangement of the wall 10A is similar to that in Embodiment 1, so that a slit 11d is disposed on the inner side of the wall 10A and a slit 11 e is disposed along the peripheral portion of the vibrating membrane 3, respectively, thereby a vibrating portion 12D is formed in a region on the inner side of a joining portion in which the vibrating membrane 3 and the wall 10A are joined and a vibrating portion 12E is formed in a region between the outer periphery of the joining portion and the peripheral portion of the vibrating membrane 3, respectively.

In the same manner as the vibrating portions 12A and 12C described in Embodiment 1 above and the variation thereof, the vibration characteristics of the vibrating portions 12D and 12E vary depending on the material composing the vibrating membrane 3, the thickness, and the shape and arrangement of the wall 10A, and the slits 11d and 11e.

Therefore, also in the MEMS element of the present variation, the vibration characteristics of the vibrating portions 12D and 12E are respectively adjusted, and a detection signal output from the vibrating portion 12D and a detection signal output from the vibrating portion 12E are added to be output. The adjustment of the vibration characteristics of the vibrating portions 12D and 12E is to be carried out such that each amplitude of vibration becomes large and the area of the region with the large amplitude increases. As a result, the area of the region with the large amplitude can be increased and a sufficiently large SNR can be obtained.

Besides, the MEMS element of the present variation is also configured to comprise the wall 10A in comparison to the conventional MEMS element, so that the amplitude of the vibration of the vibrating portions 12D and 12E is small. In other words, a detection signal having an improved AOP is output from each of the vibrating portions.

Moreover, in the MEMS element of the present variation, as a slit corresponding to the slit 11b described in the MEMS element 100 of Embodiment 1, a slit having an opening elongated in the radial direction of the vibrating membrane 3 can also be further added in a plurality along the outer periphery of the wall 10A. In a case that the structure comprising such a slit corresponding to the slit 11b is employed, the amplitude of the vibration of the vibrating portion 12E can further be increased.

### (Embodiment 2)

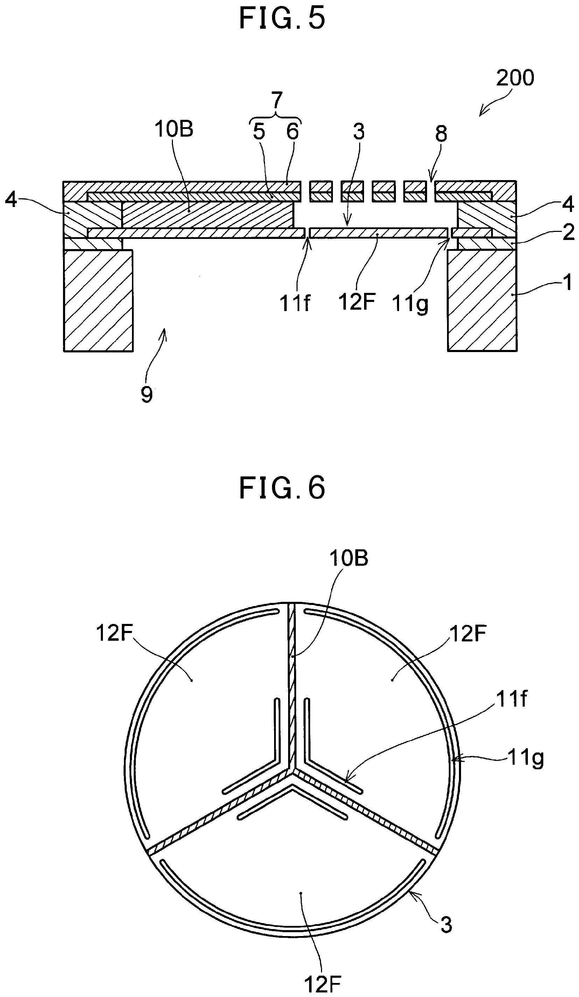

Next, Embodiment 2 of the MEMS element of the present invention will be described. FIG. 5 is a schematic cross-sectional view to explain Embodiment 2 of the MEMS element of the present invention. As shown in FIG. 5, in a MEMS element 200 according to Embodiment 2, in the same manner as in Embodiment 1 above, the insulating film 2 composed of a thermal oxide film and the like, for example, is formed on the substrate 1 as a support substrate, which substrate 1 is composed of a silicon substrate and the like, for example, and the vibrating membrane 3 including a conductive movable electrode which is composed of polysilicon and the like, for example, is formed on the insulating film 2. Moreover, the insulating spacer 4 composed of a USG and the like, for example, and the backplate 7 are laminated, which backplate 7 includes the conductive fixed electrode 5 composed of polysilicon and the like, for example, and the insulating film 6 composed of a silicon nitride and the like, for example.

In the MEMS element 200 of the present embodiment, each of the vibrating membrane 3 and the backplate 7 is joined to a wall 10B and connected to each other, and a slit 11f disposed along the wall 10B and a slit 11g disposed along the peripheral portion of the vibrating membrane 3 are provided.

FIG. 6 is a schematic plan view showing a part of the vibrating membrane 3 in the MEMS element 200 shown in FIG. 5 and is a view to explain the arrangement of the wall 10B, and the slits 11f and 11g. The back chamber 9 formed in the substrate 1 in FIG. 5 is circular and the outer periphery in FIG. 6 corresponds to the inner periphery of the spacer 4 on the substrate 1. The schematic cross-sectional view shown in FIG. 5 is a cross-sectional view passing through the center of the vibrating membrane 3, the wall 10B, and the slits 11f and 11g in FIG. 6.

As shown in FIG. 6, in a case that a portion of the vibrating membrane 3, which portion corresponds to the back chamber 9, is circular, the wall 10B extending in directions mutually different from the center of the vibrating membrane 3 toward the peripheral portion thereof and being joined at the center is disposed. The wall 10B is joined to the spacer 4 at the peripheral portion of the vibrating membrane 3. The slit 11f is disposed along the wall 10B in proximity to the center of the vibrating membrane 3 and the slit 11g is disposed along the peripheral portion of the vibrating membrane 3, respectively, thereby vibrating portions 12F are respectively formed in regions between a portion in which the vibrating membrane 3 and the wall 10B are joined and the peripheral portion of the vibrating membrane 3.

As shown in FIG. 6, the vibrating membrane 3 is partitioned into three regions by the wall 10B and each of regions between the slit 11f and the slit 11g is the independent vibrating portion 12F. The vibrating membrane 3 is evenly partitioned by the wall 10B so that each of the vibrating portions 12F constitutes a vibrating portion with uniform characteristics. In the present embodiment, the wall 10B extends in the radial direction from the center of the vibrating membrane 3 with circular shape and the joining angle of the walls 10B extending in mutually different directions is 120 degrees.

One vibrating portion being taken as one example will be described in detail. The slit 11f is formed along a portion of the vibrating membrane 3 shown in FIG. 6, which portion is joined to the wall 10B. By forming the slit 11f, it is made easy for a region, a vibration of which region is restricted by the wall 10B, to vibrate. Moreover, the slit 11g is formed along the peripheral portion of the vibrating membrane 3. By forming the slit 11g, it is made easy for a region, a vibration of which region is restricted by being joined to the wall 11B, the spacer 4, the insulating film 2, and the substrate 1 to vibrate, and a region between the slit 11f and the slit 11g is the vibrating portion 12F. The vibration characteristic of the vibrating portion 12F varies depending on the material composing the vibrating membrane 3, the thickness, and the size of the region to be the vibrating portion 12F. Moreover, the vibration characteristic also varies depending on the shape and arrangement of the slits 11f and 11g.

In this way, a region surrounded by the slits 11f and 11g is the one vibrating portion 12F. The three vibrating portions 12F are vibrating portions with uniform characteristics by the three vibrating portions 12F being disposed evenly around the center of the vibrating membrane 3.

In the MEMS element 200 of the present embodiment, the vibration characteristic of each of the vibrating portions 12F is adjusted, and detection signals output from each of the vibrating portions 12F are added to be output. The adjustment of the vibration characteristic of the vibrating portions 12F is to be carried out such that each amplitude of vibration of the vibrating portions 12F is large and the area with the large amplitude increases. As a result, a sufficiently large SNR can be obtained.

Besides, the MEMS element 200 of the present embodiment is configured to comprise the wall 10B in comparison to the conventional MEMS element, so that the amplitude of the vibration of the vibrating portions 12F is small. In other words, a detection signal having an improved AOP is output from each of the vibrating portions 12F.

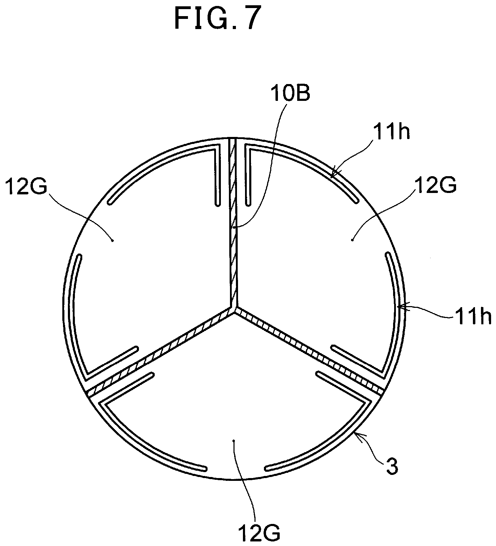

Next, a variation of Embodiment 2 of the MEMS element of the present invention will be described. FIG. 7 is a schematic plan view showing a part of the vibrating membrane 3 in the MEMS element of the variation of Embodiment 2 and is a schematic plan view corresponding to FIG. 6 in Embodiment 2. In the MEMS element of the present variation, in the same manner as the MEMS element 200 of Embodiment 2, each of the vibrating membrane 3 and the backplate 7 is joined to the wall 10B and connected to each other, and a slit 11h, a part of which is disposed along the wall 10B, is provided. Moreover, a part of the slit 11h is disposed along the peripheral portion of the vibrating membrane 3.

As shown in FIG. 7, the arrangement of the wall 10B is similar to that in Embodiment 2, and the slit 11h is disposed along the wall 10B and the peripheral portion of the vibrating membrane 3, thereby vibrating portions 12G are respectively formed in regions between a portion in which the vibrating membrane 3 and the wall 10B are joined and the peripheral portion of the vibrating membrane 3.

In the same manner as the vibrating portion 12F described in Embodiment 2 above, the vibration characteristic of the vibrating portion 12G varies depending on the material composing the vibrating membrane 3, the thickness, and the shape and arrangement of the wall 10B and the slit 11h.

Therefore, also in the MEMS element of the present variation, the vibration characteristic of the vibrating portions 12G are respectively adjusted, and detection signals output from each of the vibrating portions 12G are added to be output. The adjustment of the vibration characteristics of the vibrating portions 12G is to be carried out such that each amplitude of vibration becomes large and the area of the region with the large amplitude increases. As a result, a sufficiently large SNR can be obtained.

Besides, the MEMS element of the present variation is also configured to comprise the wall 10B in comparison to the conventional MEMS element, so that the amplitude of the vibration of the vibrating portions 12G is small. In other words, a detection signal having an improved AOP is output from each of the vibrating portions 12G.

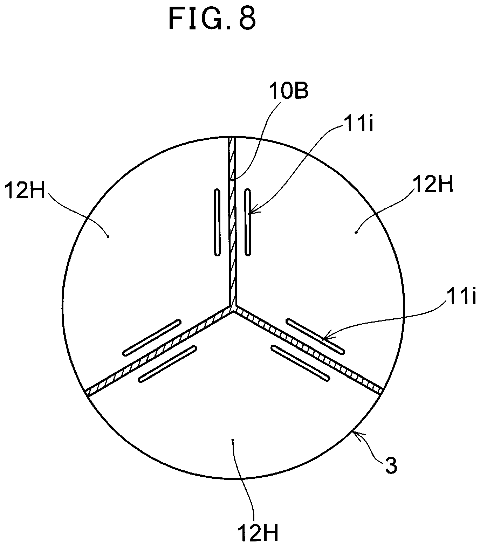

Next, another variation of Embodiment 2 of the MEMS element of the present invention will be described. FIG. 8 is a schematic plan view showing a part of the vibrating membrane 3 in the MEMS element of another variation of Embodiment 2 and is a schematic plan view corresponding to FIG. 6 in Embodiment 2. In the MEMS element of the present variation, in the same manner as the MEMS element 200 of Embodiment 2, each of the vibrating membrane 3 and the backplate 7 is joined to the wall 10B and connected to each other. Moreover, the MEMS element of the present variation is similar to the MEMS element of Embodiment 2 in that it comprises a slit along a portion joined to the wall 10B and is different from Embodiment 2 in that no slit is disposed along the peripheral portion of the vibrating membrane 3. A slit 11 i of the present variation is disposed in a region between the center and the peripheral portion of the vibrating membrane 3.

As shown in FIG. 8, the arrangement of the wall 10B is similar to that in Embodiment 2 and the slit 11i is disposed along the wall 10B, thereby vibrating portions 12H are respectively formed in regions between a portion in which the vibrating membrane 3 and the wall 10B are joined and the peripheral portion of the vibrating membrane 3.

In the same manner as the vibrating portion 12F described in Embodiment 2 above, the vibration characteristic of the vibrating portion 12H varies depending on the material composing the vibrating membrane 3, the thickness, and the shape and arrangement of the wall 10B and the slit 11i.

Therefore, also in the MEMS element of the present variation, each vibration characteristic of the vibrating portions 12H is adjusted, and detection signals output from each of the vibrating portions 12H are added to be output. The adjustment of the vibration characteristic of the vibrating portions 12H is to be carried out such that each amplitude of vibration becomes large and the area of the region with the large amplitude increases. As a result, a sufficiently large SNR can be obtained.

Besides, the MEMS element of the present variation is also configured to comprise the wall 10B in comparison to the conventional MEMS element, so that the amplitude of the vibration of the vibrating portions 12H is small. In other words, a detection signal having an improved AOP is output from each of the vibrating portions 12H.

In the present Embodiment 2 and the variations thereof, a case is described in which the wall 10B extends in mutually different directions in the radial direction from the center of the vibrating membrane 3 and the joining angle of the wall 10B is 120 degrees. However, the MEMS element of the present invention is not limited thereto, so that, for example, the wall 10B can be disposed such that the joining angle of the wall 10B is 90 degrees to form four vibrating portions or the wall 10B can be disposed such that the joining angle of the wall 10B is 60 degrees to form six vibrating portions.

### (Embodiment 3)

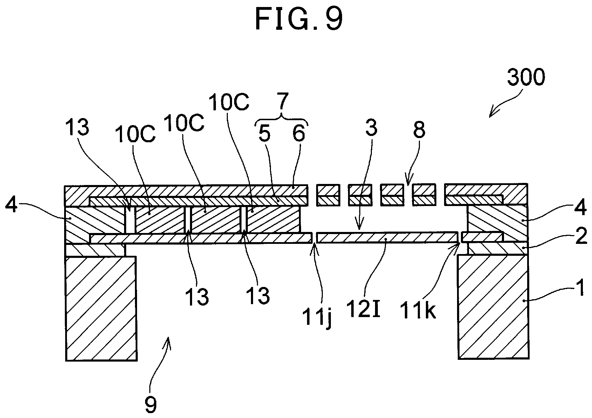

Next, Embodiment 3 of the MEMS element of the present invention will be described. FIG. 9 is a schematic cross-sectional view to explain Embodiment 3 of the MEMS element of the present invention. As shown in FIG. 9, in the same manner as in Embodiments 1 and 2 above, in a MEMS element 300 according to Embodiment 3, the insulating film 2 composed of a thermal oxide film and the like, for example, is formed on the substrate 1, as the support substrate 1, composed of a silicon substrate and the like, for example, and the vibrating membrane 3 including a conductive movable electrode which is composed of polysilicon and the like, for example, is formed on the insulating film 2. Moreover, the insulating spacer 4 composed of a USG and the like, for example, and the backplate 7 are laminated, which backplate 7 includes the conductive fixed electrode 5 composed of polysilicon and the like, for example, and the insulating film 6 composed of a silicon nitride and the like, for example.

In the MEMS element 300 of the present embodiment, each of the vibrating membrane 3 and the backplate 7 is joined to walls 10C and connected to each other, which walls 10C are disposed in intermittent rows, and the MEMS element 300 of the present embodiment comprises a slit 11j disposed along the walls 10C and a slit 11k disposed along the peripheral portion of the vibrating membrane 3.

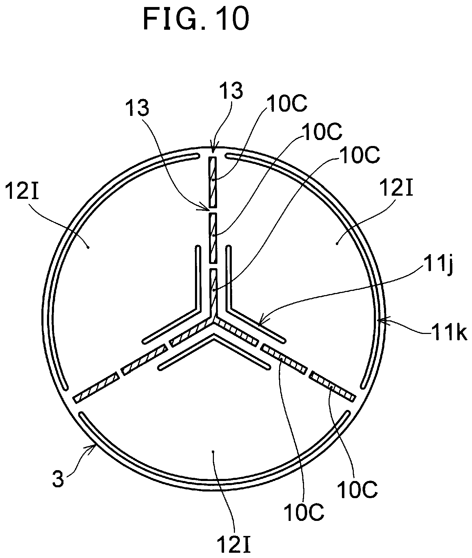

FIG. 10 is a schematic plan view showing a part of the vibrating membrane 3 in the MEMS element 300 shown in FIG. 9 and is a view to explain the arrangement of the walls 10C, and the slits 11j and 11k. In FIG. 9, the back chamber 9 formed in the substrate 1 is circular and the outer periphery in FIG. 10 corresponds to the inner periphery of the spacer 4 on the substrate 1. The schematic cross-sectional view shown in FIG. 9 is a cross-sectional view passing through the center of the vibrating membrane 3, the walls 10C in rows, and the slits 11j and 11k in FIG. 10.

As shown in FIG. 10, in a case that a portion of the vibrating membrane 3, which portion corresponds to the back chamber 9, is circular, the walls 10C extending in directions mutually different from the center of the vibrating membrane 3 toward the peripheral portion of the vibrating membrane 3 and being joined at the center are disposed in intermittent rows. At the peripheral portion of the vibrating membrane 3, the walls 10C are not joined to the spacer 4, so that a gap 13 is formed. Vibrating portions 121 are respectively formed in regions between, rows of portions in which the vibrating membrane 3 and the walls 10C are joined, and the peripheral portion of the vibrating membrane 3.

As shown in FIG. 10, the vibrating membrane 3 is partitioned into three regions by the walls 10C in rows, and each of regions between the slit 11j and the slit 11k is the independent vibrating portion 121. Each of the vibrating portions 121 constitutes a vibrating portion with uniform characteristics, so that the vibrating membrane 3 is evenly partitioned by the walls 10C in rows. In the present embodiment, the walls 10C in rows extend in the radial direction from the center of the vibrating membrane 3 and the joining angle of the walls 10C in rows disposed so as to extend in directions mutually different is 120 degrees.

One vibrating portion being taken as one example will be described in detail. The slit 11j is formed along a portion of the vibrating membrane 3 shown in FIG. 10, which portion is in rows and is joined to the wall 10C. By forming the slit 11j, it is made easy for a region, a vibration of which region is restricted by the walls 10C, to vibrate. Moreover, the slit 11k is formed along the peripheral portion of the vibrating membrane 3. By forming the slit 11k, it is made easy for a region, a vibration of which region is restricted by being joined to the walls 10C, the spacer 4, the insulating film 2, and the substrate 1, to vibrate, and a region between the slit 11j and the slit 11k is the vibrating portion 121. The vibration characteristic of the vibrating portion 121 varies depending on the material composing the vibrating membrane 3, the thickness, and the size of the region to be the vibrating portion 121. Moreover, the vibration characteristic varies also depending on the shape and arrangement of the slits 11j and 11k and further depending on the shape and arrangement of the walls 10C.

In this way, a region surrounded by the slits 11j and 11k is the one vibrating portion 121. The three vibrating portions 121 are vibrating portions with uniform characteristics by the three vibrating portions 121 being disposed evenly around the center of the vibrating membrane 3.

In the MEMS element 300 of the present embodiment, the vibration characteristic of each of the vibrating portions 121 is adjusted, and detection signals output from each of the vibrating portions 121 are added to be output. The adjustment of the vibration characteristic of the vibrating portions 121 is to be carried out such that each amplitude of vibration becomes large and the area of the region with the large amplitude increases. As a result, a sufficiently large SNR can be obtained. In particular, since the gap 13 is disposed between the walls 10C, the MEMS element 300 of the present embodiment has a structure in which spaces (air gaps) on each of the vibrating portions 121 are communicatively connected, so that each of the vibrating portions interferes with each other, thus, it is possible to obtain a large SNR.

Besides, the MEMS element 300 of the present embodiment comprises the walls 10C in comparison to the conventional MEMS element, so that the amplitude of the vibration of the vibrating portions 12l is small. In other words, a detection signal having an improved AOP is output from each of the vibrating portions 121.

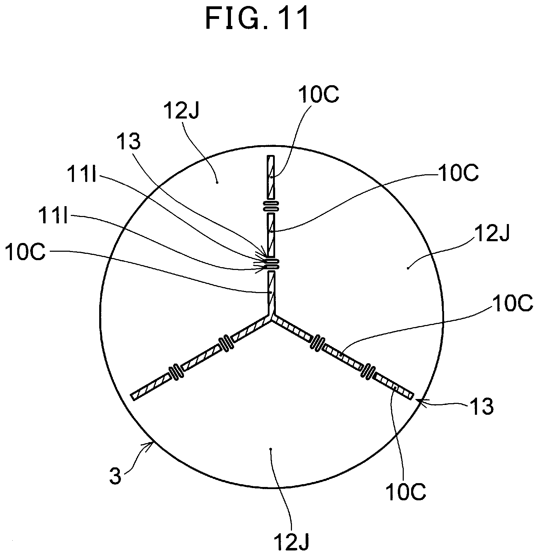

Next, a variation of Embodiment 3 of the MEMS element of the present invention will be described. FIG. 11 is a schematic plan view showing a part of the vibrating membrane 3 in the MEMS element of the variation of Embodiment 3 and is a schematic plan view corresponding to FIG. 10 in Embodiment 3. In the MEMS element of the present variation, in the same manner as the MEMS element 300 of Embodiment 3, each of the vibrating membrane 3 and the backplate 7 is joined to the walls 10C and connected to each other. Moreover, the MEMS element of the present variation is similar to the MEMS element 300 of Embodiment 3 in that it comprises a slit disposed along a portion joined to the walls 10C and differs in the shape and arrangement of the slit. A slit 111 of the present variation is disposed in the gap 13 sandwiched by the two walls 10C and the tip of the slit 11l is shaped so as to reach the region of each of vibrating portions 12J.

As shown in FIG. 11, the arrangement of the walls 10C is similar in Embodiment 3, and the slit 11l is disposed in the gap 13 sandwiched by the two walls 10C along the walls 10C, thereby the vibrating portions 12J are respectively formed in regions between a portion in which the vibrating membrane 3 and the wall 10C are joined and the peripheral portion of the vibrating membrane 3.

In the same manner as the vibrating portion 121 described in Embodiment 3 above, the vibration characteristic of the vibrating portion 12J varies depending on the material composing the vibrating membrane 3, the thickness, and the shape and arrangement of the walls 10C and the slit 11l.

Therefore, also in the MEMS element of the present variation, the vibration characteristic of each of the vibrating portions 12J is adjusted, and detection signals output from each of the vibrating portions 12J are added to be output. The adjustment of the vibration characteristic of the vibrating portions 12J is to be carried out such that each amplitude of vibration becomes large and the area of the region with the large amplitude increases. As a result, a sufficiently large SNR can be obtained.

Besides, the MEMS element of the present variation also comprises the walls 10C in comparison to the conventional MEMS element, so that the amplitude of vibration of the vibrating portion 12J is small. In other words, a detection signal having an improved AOP is output from each of the vibrating portions 12J.

In the present Embodiment 3 and the variation thereof, a case is described of the walls 10C extending in directions mutually different in the radial direction from the center of the vibrating membrane 3 and being disposed in intermittent rows and the joining angle thereof being 120 degrees. However, the MEMS element of the present invention is not limited thereto, so that, for example, the walls 10C can be disposed such that the joining angle thereof is 90 degrees, forming four vibrating portions, or the walls 10C can be disposed such that the joining angle thereof is 60 degrees, forming six vibrating portions. Moreover, the walls 10C can also be configured to be not joined at the center of the vibrating membrane 3, or in other words, to be not disposed at the center of the vibrating membrane 3. The number of the slits 11l disposed in the gap 13 is not limited to two.

### (Embodiment 4)

Next, Embodiment 4 of the MEMS element of the present invention will be described. In the MEMS element according to Embodiment 4, a region in which a vibrating portion is formed, or in other words the position at which a wall is formed is similar to that in Embodiment 1 above and a gap being present in a wall is similar in Embodiment 3. Specifically, when the MEMS element according to the present Embodiment is described as a MEMS element having a vibrating membrane, a part of which is shown in FIG. 12, a schematic cross-sectional view of the MEMS element, in a case that the cross-section is a cross-section passing through the wall 10D and the center of the vibrating membrane 3, differs from the schematic cross-sectional view of Embodiment 1 shown in FIG. 1, only in that the slits 11a, 11b are not present. Therefore, in making description with reference to FIG. 1, in the same manner as in Embodiment 1 above, the insulating film 2 composed of a thermal oxide film and the like, for example, is formed on the substrate 1, as the support substrate 1, composed of a silicon substrate and the like, for example, and the vibrating membrane 3 including a conductive movable electrode which is composed of polysilicon and the like, for example, is formed on the insulating film 2. Moreover, the insulating spacer 4 composed of a USG and the like, for example, and the backplate 7 are laminated, which backplate 7 includes the conductive fixed electrode 5 composed of polysilicon and the like, for example, and the insulating film 6 composed of a silicon nitride and the like, for example.

FIG. 12 is a schematic plan view to explain a MEMS element according to Embodiment 4, which is a schematic plan view corresponding to FIG. 2 in Embodiment 1 and shows a part of the vibrating membrane 3 in the MEMS element, In comparison to the MEMS element 100 of Embodiment 1, the MEMS element according to the present Embodiment 4 differs in the shape and arrangement of a wall 10D and a slit 11m. The walls 10D of the present Embodiment are disposed in intermittent rows. Moreover, the slit 11m is disposed in the gap 13 sandwiched by the two walls 10D along the walls 10D and the tip of the slit 11m is shaped so as to reach the region of each of vibrating portions 12K and 12L.

As shown in FIG. 12, the slit 11m is disposed in the gap 13 sandwiched by the two walls 10D along the wall 10D, thereby the vibrating portions 12K and 12L are formed in a region on the inner side of a joining portion in which the vibrating membrane 3 and the wall 10D are joined and in a region between the outer periphery of the joining portion and the peripheral portion of the vibrating membrane 3, respectively.

In the same manner as the vibrating portions 12A and 12B described in Embodiment 1 above, the vibration characteristics of the vibrating portions 12K and 12L vary depending on the material composing the vibrating membrane 3, the thickness, and the shape and arrangement of the walls 10D and the slit 11m.

Therefore, also in the MEMS element of the present Embodiment, the vibration characteristic of each of the vibrating portions 12K and 12L is adjusted, and a detection signal output from the vibrating portion 12K and a detection signal output from the vibrating portion 12L are added to be output. The adjustment of the vibration characteristic of the vibrating portions 12K and 12L is to be carried out such that each amplitude of vibration becomes large and the area of the region with the large amplitude increases. As a result, a sufficiently large SNR can be obtained.

Besides, the MEMS element of the present Embodiment comprises the walls 10D in comparison to the conventional MEMS element, so that the amplitude of vibration of the vibrating portions 12K and 12L is small. In other words, a detection signal having an improved AOP is output from each of the vibrating portions 12K and 12L.

Moreover, in the MEMS element of the present Embodiment, instead of the slit 11m, slits corresponding to the slit 11a and the slit 11b being described in the MEMS element 100 of Embodiment 1 can also be disposed along the inner side of the walls 10D in rows and along the outer periphery of the walls 10D in rows, respectively. Furthermore, slits corresponding to the slit 11a and the slit 11c being described in the MEMS element of the variation of Embodiment 1 can also be disposed along the inner side of the walls 10D in rows and along the peripheral portion of the vibrating membrane 3, respectively and a slit corresponding to the slit 11b can also be disposed along the outer periphery of the walls 10D in rows.

In the Embodiments above, it is described that a vibration characteristic of a plurality of vibrating portions is adjusted such that each amplitude of vibration becomes large and the area of the region with the large amplitude increases, but the present invention is not limited to such an aspect, so that the vibration characteristic of each of the vibrating portions can be appropriately set and a detection signal output from each of the vibrating portions can be added to turn to a desired detection signal. Moreover, the arrangement of slits can be changed variously, such as slits being disposed in two rows, so that they are disposed in a staggered manner, or a combination of slits described in each of Embodiments being disposed.

### (Summary)

(1) A MEMS element of the present invention, in one Embodiment, can be configured as a MEMS element comprising: a substrate comprising a back chamber; a vibrating membrane joined onto the substrate, wherein the vibrating membrane comprises a movable electrode; and a backplate comprising a fixed electrode disposed so as to face the movable electrode, wherein the vibrating membrane has a wall connecting the backplate and the vibrating membrane, a slit disposed along at least either one of a portion joined to the wall and a peripheral portion of the vibrating membrane, and a plurality of vibrating portions, wherein each of the plurality of vibrating portions is present in either one of: (i) a region surrounded by a portion in which the wall and the vibrating membrane are joined, and (ii) a region between the portion in which the wall and the vibrating membrane are joined and the peripheral portion of the vibrating membrane, and wherein at least one of the plurality of vibrating portions is present in the region of (ii).
   According to the MEMS element of the present Embodiment, a wall is disposed in a vibrating membrane, thereby the amplitude of the vibrating membrane is suppressed and, moreover, by providing the vibrating membrane with a slit, it is possible to adjust the vibration characteristic of a vibrating portion. The vibrating portion is formed in a plurality, so that it is possible to obtain a detection signal having an improved AOP without decreasing the SNR as a whole.
(2) The wall can be disposed so as to surround a central portion of the vibrating membrane.
(3) All of the plurality of vibrating portions can be present in the region of (ii); and the wall can be disposed so as to extend in directions mutually different from a center of the vibrating membrane toward the peripheral portion of the vibrating membrane.
(4) The wall can be disposed in intermittent rows, the slit can be disposed along the wall, and it is possible to obtain a detection signal having an improved AOP without decreasing the SNR.

### REFERENCE SIGNS LIST

1 SUBSTRATE
2 INSULATING FILM
3 VIBRATING MEMBRANE
4 SPACER
5 FIXED ELECTRODE
6 INSULATING FILM
7 BACKPLATE
8 ACOUSTIC HOLE
9 BACK CHAMBER
10A to 10D WALL
11a to 11m SLIT
12A to 12K VIBRATING PORTION
13 GAP

## Claims

1. A MEMS element comprising:
a substrate comprising a back chamber;
a vibrating membrane joined onto the substrate, wherein the vibrating membrane comprises a movable electrode; and
a backplate comprising a fixed electrode disposed so as to face the movable electrode,
wherein the vibrating membrane has a wall connecting the backplate and the vibrating membrane, a slit disposed along at least either one of a portion joined to the wall and a peripheral portion of the vibrating membrane, and a plurality of vibrating portions,
wherein each of the plurality of vibrating portions is present in either one of:
(i) a region surrounded by a portion in which the wall and the vibrating membrane are joined, and
(ii) a region between the portion in which the wall and the vibrating membrane are joined and the peripheral portion of the vibrating membrane, and
wherein at least one of the plurality of vibrating portions is present in the region of (ii).

2. The MEMS element according to claim 1,
wherein the wall is disposed so as to surround a central portion of the vibrating membrane.

3. The MEMS element according to claim 1,
wherein all of the plurality of vibrating portions are present in the region of (ii); and
wherein the wall is disposed so as to extend in directions mutually different from a center of the vibrating membrane toward the peripheral portion of the vibrating membrane.

4. The MEMS element according to any one of claims 1 to 3,
wherein the wall is disposed in intermittent rows; and
wherein the slit is disposed along the wall.
